# EUROPÄISCHE PATENTSCHRIFT

(11) **EP 1 864 313 B1**
(45) Veröffentlichungstag und Bekanntmachung des Hinweises auf die Patenterteilung: **19.12.2012**
(21) Anmeldenummer: 06705364.5
(22) Anmeldetag: 01.03.2006
(51) Int. Cl.: H02M 7/10, H02M 7/5387, H01J 37/32, H01J 37/34

(54) **VAKUUMPLASMAGENERATOR**
VACUUM PLASMA GENERATOR
GENERATEUR DE PLASMA SOUS VIDE

(30) Priorität: 24.03.2005 CH 5182005; 03.08.2005 CH 12902005
(43) Veröffentlichungstag der Anmeldung: 12.12.2007
(73) Patentinhaber: Oerlikon Trading AG, Trübbach, 9477 Trübbach (CH)
(72) Erfinder: TUYMER, Gerhard, A-4701 Bad Schallerbach (AT); RAMM, Jürgen, CH-7304 Maienfeld (CH); LENDI, Daniel, CH-9472 Grabs (CH)
(74) Vertreter: Wegmann, Urs
(86) Internationale Anmeldenummer: PCT/CH2006/000124
(87) Internationale Veröffentlichungsnummer: WO 2006/099759

(56) Entgegenhaltungen:
- EP-A- 0 534 068
- EP-A- 1 278 294
- EP-A- 1 434 336
- US-A- 5 461 297
- US-B1- 6 296 742

## Beschreibung

Die Erfindung bezieht sich auf einen Vakuumplasmagenerator zur Speisung einer Plasmaentladung zur Behandlung von Werkstücken in einer Vakummkammer, gemäss Oberbegriff von Anspruch 1.

Elektrische Speisegeräte zum Betreiben von Gasentladungen beziehungsweise Plasmaentladungen für Vakuumprozesse sind auf vielerlei Art und Weise bereits bekannt geworden. Solche elektrische Speisegeräte werden in der Fachwelt auch als Generatoren bezeichnet. Es ist hierbei wichtig die Beitriebsbedingungen gut und zuverlässig kontrollieren zu können, weil die Natur der Plasmaentladungen und des damit verbundenen Plasmaprozesses besondere Anforderungen stellt. Mit derartigen Vakuumplasmaprozessen werden heute eine vielzahl von verschiedenen Anwendungen abgedeckt, wie beispielsweise Beschichten, Reinigen, thermische Behandlung von Werkstücken beziehungsweise von Substraten etc.

Derartige Plasmaprozesse sind beispielsweise das Kathodenzerstäuben, das Funkenverdampfen auch Arcverdampfen genannt, Oberflächenbehandlungen durch Elektronen- oder Ionenbeschuss und Plasma-CVD Abscheideverfahren. Um spezielle Ergebnisse erzielen zu können bei derartigen Plasmaprozessen, müssen die Entladungsvorgänge entsprechend beherrscht werden und gezielt mit Hilfe geeigneter Stromversorgungen gesteuert werden. Hierbei ist das mögliche Parameterfeld der verschiedenen Betriebsmoden derartiger Plasmaentladungen sehr breit und es können immer wieder neue und überraschende Ergebnisse erzielt werden, wie beispielsweise bei den Schichteigenschaften von beschichteten Werkstücken. Seit einiger Zeit wird deshalb versucht mit pulsierend gespiesenen Plasmaentladungen das Parameterfeld zusätzlich zu erweitern, um neue Möglichkeiten realisieren zu können. Hierbei werden unipolare Pulse oder bipolare Pulse verwendet, bei verschiedenen Frequenzen oft im kHz bis über den 100 kHz Bereich und auch mit unterschiedlichen Pulsbreiten und/oder Pulsformen. Mit dieser Pulstechnologie kann beispielsweise bei schlecht leitenden Materialien oder gar isolierenden Schichten gearbeitet werden, ohne dass unerwünschte Funkenentladungen entstehen. Insbesondere bei dem wichtigen Anwendungsfall des Substratbias führt die Pulstechnik zu positiven Resultaten, hierbei wurde in der Regel mit einer spannungsstabilen gepulsten Stromversorgung gearbeitet mit der sich auch hohe Ströme realisieren lassen. Mit der Pulstechnik können auch zur Erzeugung von Beschichtungen Beschichtungsquellen gespiesen werden, bei-spielsweise Zerstäubungsquellen bzw. Sputterquellen oder auch Funkenverdampfungsquellen.

Die Pulstechnologie ist besonders gut geeignet zur Beherrschung von Prozessen mit schlecht oder nicht leitenden Materialien, wie beispielsweise reaktive Prozesse. Der Einsatz dieser Technologie bringt aber auch enorme Vorteile bei der Verwendung von elektrisch gut leitenden Materialien im Prozess, wie beispielsweise zur Einstellung der Stöchiometrie von Schichten, Dichte des Schichtmaterials und aber auch zur Beeinflussung der Struktur.

Wegen der Vielfältigkeit der Möglichkeiten wird heute mit dem ganzen Spektrum der bekannten Plasmaentladungsarten beziehungsweise Plasmabetriebsmoden gearbeitet.

In der US 05,303,139 wird eine bipolare Stromversorgung eingesetzt, welche umfangreich Pulsplasmaanwendungen im Bereich von sogenannten Glimmentladungen beschreibt im Gebiet von PVD und CVD Anwendungen. Die Glimmentladungen arbeiten üblicherweise bei Spannungen unter 1000 Volt, also bei einigen 100 Volt und kleinen Stromwerten. Oft werden derartige Glimmentladungen zusätzlich mit speziellen Magnetfeldern unterstützt. Quellen dieser Art sind als Magnetronquellen bekannt geworden. Diese werden bei einigen 100 Volt betrieben und erlauben höhere Entladeströme zu realisieren, als die Glimmentladung ohne Magnetfeldunterstützung.

Abnormale Glimmentladungen, wie sie beispielsweise in der US 5,015,493 beschrieben sind, werden bei höheren Spannungen von einigen Kilovolt betrieben und bei höheren Stromwerten als denen der Glimm- oder Magnetronentladungen, aber bei kleineren Stromwerten verglichen mit der Funkenentladung.

Funkenverdampfer oder auch Arcverdampfer genannt, werden im Bereich von einigen 10 Volt betrieben, aber bei sehr hohen Strömen von üblicherweise einigen 100 Ampère.

Eine weitere spezielle Entladungsform ist aus US 6, 296, 742 bekannt geworden, das sogenannte "High Power Pulsed Sputtering".

Dieser Betriebsmodus wird manchmal auch als "diffused discharge" bezeichnet, da es zu einer markanten diffusen Aufhellung des Plasmas im Targetbereich kommt. Die Entladung wird hierbei mit Pulsspannungen von 0,35 bis 5 kV betrieben bei Pulsleistungen von 10 kW bis 1 MW. Die Pulslängen liegen im Bereich von 50 Mikrosekunden bis 1 Millisekunde und das Intervall zwischen den Pulsen im Bereich von 10 Millisekunden bis 1000 Sekunden.

Die vorerwähnten Plasmaprozesse bzw. Plasmabehandlungsverfahren stellen für die Stromversorgung eine Last dar, welche einen sehr breiten Impedanzbereich abdecken und somit Speisespannungen benötigen im Bereich von einigen Volt bis in den kV-Bereich und Spulsströme von einigen Ampere bis einige 100 Ampere bei Pulsfrequenzen von kHz bis einige 100 kHz. Bis anhin mussten für jeden Einsatzbereich separate, entsprechend auf die Last bzw. auf den entsprechenden Plasmabetriebsmode ausgelegte Stromversorgungen, verwendet werden. Will man mit konventionellen Generatoren einen weiteren Spannungsbereich abdecken, ergibt sich der Nachteil, dass die Bauleistung des Generators dem Produkt aus maximaler Ausgangsspannung und maximalem Ausgangsstrom entsprechen muss, wobei Verfahren, die kleine Spannungen benötigen, meist höhere Ströme benötigen als Verfahren mit hoher Spannung, so dass die Bauleistung unnötig gross ausfallen würde.

Ein weiterer Nachteil konventioneller Generatoren, die über einen weiten Ausgangsspannungsbereich eingesetzt werden, ist die relative Verringerung der Qualität beim Betrieb mit kleiner Ausgangsspannung. Beispielsweise wird dadurch die Auflösung verringert bei Erhöhung der Welligkeit. Ein weiterer besonders grosser Nachteil besteht darin, dass die Pulsform oft nicht stabil ist und sich verändert während dem Betrieb abhängig vom Lastverhalten und dann insbesondere die Flankensteilheiten der Pulse variiert oder gar abflacht und sich nicht genügend steile Pulsflanken erzeugen lassen. Bei den heute durchgeführten Plasmaprozessen zur Bearbeitung von Werkstückoberflächen, wie insbesondere zur Abscheidung von Schichten, sollten verschiedene der vorerwähnten Plasmabetriebsmoden innerhalb des Produktionsprozesses in der gleichen Vakuumprozessanlage betrieben werden können. Dies sowohl bei einzelnen Plasmaquellenanordnungen durch Steuern des Betriebsmodus und / oder auch bei mehreren verschiedenen Quellenanordnungen, die spezifisch auf die unterschiedlichen Betriebsmoden ausgelegt sind, wie beispielsweise und vorzugsweise eine Kombination von Arcverdampfer, Sputterquellen und Bias-Plasmastrecken.

In der EP 1 278 294 A1 wird eine elektrische Stromversorgung beschrieben, die besonders für Gleichstromplasmabehandlung anwendbar ist. Die dort vorgestellte Stromversorgung soll in der Lage sein eine konstante elektrische Leistung an eine Last abgeben zu können, die über einen grossen Bereich variabel ist, wie dies bei DC Plasma - Prozessen vorkommt, ohne die Hardware der Stromversorgung ändern oder wechseln zu müssen. In der Beschreibung zum Stand der Technik wird dort eine Schaltungsanordnung erwähnt, bei der ein DC-DC Konverter eine H - Brückenschaltkreis enthält mit zwei Transformatoren mit je zwei Sekundärwicklungen, welche mit Schaltern je nach Bedarf in Serie oder parallel geschaltet werden können, um damit eine Lastanpassung vornehmen zu können. Danach wird der Strom, wie üblich, gleichgerichtet und mit Induktivität und Kondensator geglättet. Die dort dargestellte Weiterbildung soll diese Schalter ersetzen. Es wird hierzu eine Schaltungsanordnung mit einer H-Brücke vorgeschlagen, bei welcher die beiden Brücken der H-Brücke je einen Transformator speisen und die Sekundärwicklungen mit einer Brückengleichrichter - Schaltung verbunden sind und dadurch die Spannungen zusammengeführt werden auf einen gemeinsamen DC- Ausgang wo wiederum eine Induktivität und ein Kondensator zur Glättung der DC - Spannung angeordnet ist. Die beiden Brücken der H-Brücke werden mit Pulsgruppen angesteuert die gegeneinander einstellbar Phasenverzögert betrieben werden können, wodurch eine Lastanpassung ermöglicht wird der am DC - Ausgang angelegten variierenden Last, insbesondere gebildet durch eine Plasmaentladung.

Die Aufgabe der vorliegenden Erfindung liegt darin, die vorerwähnten Nachteile des Standes der Technik zu beseitigen. Insbesondere besteht die Aufgabe darin, einen Vakuum-plasmagenerator zu realisieren, der einen hohen Lastimpedanzbereich abdeckt zur Speisung von mindestens zwei unterschiedlichen Plasmabetriebsmoden der vorerwähnten Art. Der Generator soll ausserdem hohe Pulsleistungen in allen Betriebsmoden ermöglichen und ein definiertes Pulsverhalten an das Plasma abgeben, um die gewünschten Schichteigenschaften realisieren zu können und dies bei hoher Wirtschaftlichkeit.

Die Aufgabe wird erfindungsgemäss durch einen Vakuumplasma-generator nach Anspruch 1 gelöst. Die abhängigen Ansprüche definieren weitere vorteilhafte Ausführungsformen.

Die Aufgabe wird erfindungsgemäss dadurch gelöst, dass ein Vakuumplasmagenerator mit einem Generatorausgang zur Speisung einer Plasmaentladung zur Behandlung von Werkstücken in einer Vakuumkammer ausgebildet ist mit einem Wechselspannungsnetzanschluss, einer Netzgleichrichteranordnung zur Umsetzung der Netzwechselspannung in eine Gleichspannung, einem Glättungskondensator, einer ersten Stufen als getakteten DC-DC-Spannungskonverter mit Mitteln zur Einstellung der DC-Ausgangsspannung, welche eine Zwischenkreisspannung bildet enthaltend einen pulsbreiten-gesteuerten Leistungsschalter, der die Primärwicklung eines Transformators speist und dessen Sekundärwicklung mit einem Gleichrichter und einem nachgeschalteten Zwischenkreiskondensator verbunden ist und einem schwebenden Transformatorsekundärkreis bildet, wobei dieser mit einer nachgeschalteten zweiten Stufe verbunden ist, welche eine Pulsausgangsstufe bildet und diese an den Generatorausgang angeschlossen ist, wobei der DC-DC-Spannungskonverter mindestens zwei schwebende Transformatorsekundärkreise aufweist und eine Umschaltvorrichtung mit einer Schaltsteuerung enthält zur wahlweisen Parallelschaltung oder seriellen Schaltung der schwebenden Transformatorsekundärkreise.

Über den vorgeschalteten DC-DC-Spannungskonverter kann die Spannung, welche in die zweite Stufe eingespeist wird, über einen grossen Bereich eingestellt werden. Der DC-DC-Konverter ist getaktet und als Schaltnetzteil ausgebildet, beispielsweise als Book-Boost-Konverter. Die eingestellte Ausgangsspannung kann dann sowohl kleiner als auch grösser als die Eingangsspannung sein. Mit der Umschaltvorrichtung können schwebende Transformatorsekundärkreise in Serie oder parallel geschaltet werden. Hierdurch ist es möglich, den Arbeitsbereich für die Speisung der Pulsausgangsstufe wesentlich zu erweitern und sich in einem grossen Bereich an verschiedene Plasmaimpedanzbereiche anzupassen. Mit Erhöhung der Anzahl von Transformatorsekundärkreisen in der ersten Stufe mit den zugehörigen Umschaltvorrichtungen kann der Spannungsbereich entsprechend dem gewünschten Einsatzbereich erweitert werden. Die Pulsausgangsstufe, welche die Plasmastrecke speist, kann somit gesteuert und immer im optimalen Arbeitsbereich betrieben werden, derart dass die Pulsform auch bei hoher Last entsprechend den Vorgaben erhalten bleibt und sich weder verformt oder gar unkontrolliert zusammenbricht.

Die Erfindung wird nun nachfolgend beispielsweise mit schematischen Figuren näher erläutert. Es zeigen:
- Fig. 1: ein Blockschema eines erfindungsgemässen Vakuumplasmagenerators
- Fig. 2: Beispiele von Ausgangsspannungsformen des Generators nach Fig. 1
- Fig. 3: Prinzipschema einer Umschaltvorrichtung für die erste Stufe des Generators
- Fig. 4: eine Variante einer Umschaltvorrichtung
- Fig. 5a: eine weitere Variante einer Umschaltvorrichtung mit zwei schwebend betriebenen, separat getakteten Konverterstufen
- Fig. 5b: Ströme und Spannungen bei phasenversetzter Taktung der Konverteranordnung nach Fig. 5a
- Fig. 6a: DC-DC-Konverterstufe
- Fig. 6b: Verlauf der Spannungen und Ströme an der Konverterstufe nach Fig. 6a bei minimaler Pulsdauer
- Fig. 7: Verlauf der Spannungen und Ströme beim Aussetzbetrieb

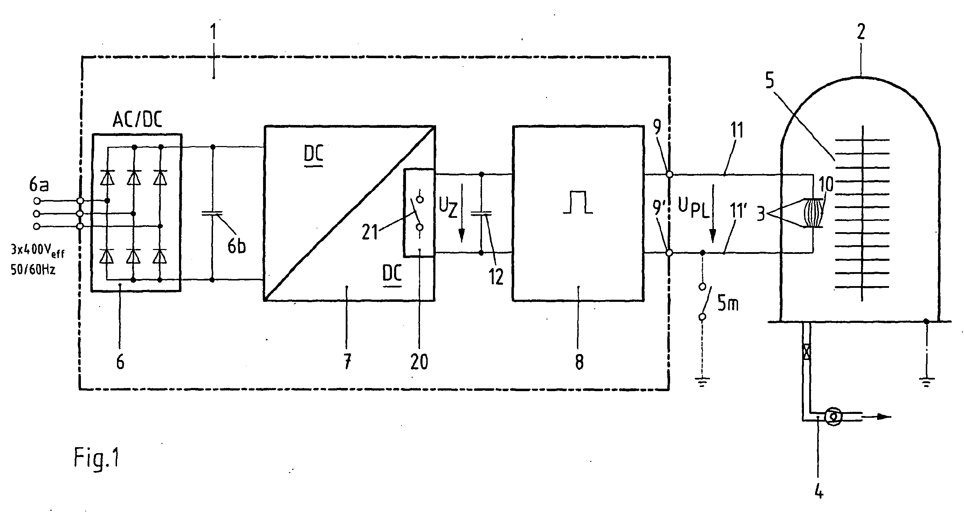

Der Generator gemäss vorliegender Erfindung verfügt über eine zweistufige Topologie wie dies in Fig. 1 schematisch dargestellt ist. Am Wechselspannungsnetzanschluss 6a wird beispielsweise eine dreiphasige Spannung von 3 x 400 V_{eff} 50/60 Hz bezogen, welche in der Netzgleichrichteranordnung 6 zu einer Gleichspannung umgewandelt wird und mit dem Glättungskondensator 6b geglättet wird. Die so erzeugte Gleichspannung wird einer ersten Stufe zugeführt, welche als DC-DC-Spannungskonverter 7 ausgebildet ist zur Erzeugung einer Zwischenkreisspannung U_{z}, welche mit einem Zwischenkreiskondensator 12 oder mehreren Zwischenkreiskondensatoren 12'-12''' geglättet wird. Der DC-DC-Spannungskonverter 7 hat die Aufgabe der nachgeschalteten zweiten Stufe, der Pulsausgangsstufe 8, einen möglichst grossen DC-Spannungsbereich als Speisung zur Verfügung zu stellen. Die Pulsausgangsstufe 8 kann hierdurch wiederum einen grossen Pulsspannungsbereich und somit einen grossen Lastimpedanzbereich an den Ausgangsklemmen 9, 9' des Generators 1 für die Speisung der Plasmastrecke 10 mit der Plasmaspannung U_{Pl} zwischen den Elektroden 3 zur Verfügung stellen. Die Elektroden 3 sind in einer Vakuumkammer 2 bzw. Prozesskammer 2 angeordnet, um Werkstücke 5 bzw. Substrate 5 in dieser Prozesskammer behandeln zu können. Die Vakuumkammer 2 wird in üblicher Weise über ein Vakuumpumpsystem 4 evakuiert und das Prozessgas wie beispielsweise Argon und insbesondere zusätzliche gewünschte Reaktivgase in die Vakuumkammer eingelassen, derart dass die Plasmaentladungen in einem Druckbereich von 5x10⁻⁴ mbar bis 10 mbar betrieben werden können. Die Elektroden 3 sind mit den elektrischen Leitungen 11, 11' für den Betrieb mit dem Generator 1 mit dessen Ausgängen 9, 9' verbunden. Die Plasmastrecke 10 kann schwebend betrieben werden, aber wenn gewünscht auch gegen Anlagemasse fixiert werden, wie dies symbolisch mit dem Masseschalter 5_{M} angedeutet ist, mit welchem eine der Zuleitungen 11, 11' gegen Masse verbunden wird.

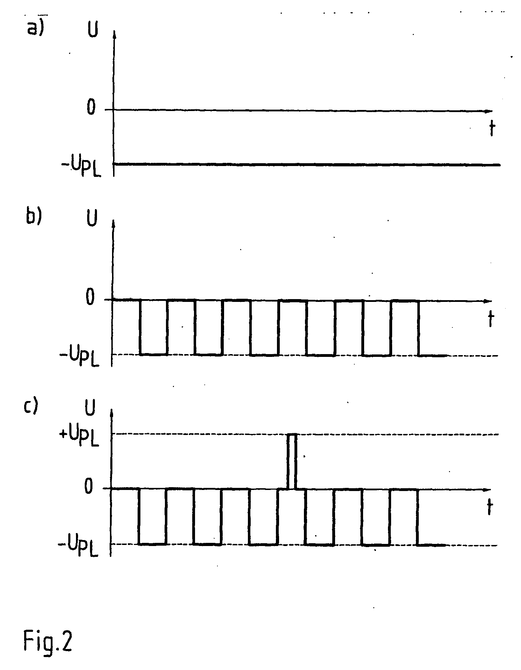

Um den grossen Arbeitsbereich des Generators 1 erzielen zu können, ist neben dem pulsbreitengesteuerten DC-DC-Spannungskonverter 7 zusätzlich eine Umschaltvorrichtung 20a, b, c vorgesehen. Der DC-DC-Konverter 7 enthält dazu eine Schaltanordnung 7b mit mindestens zwei Transformatorsekundärkreise 23, welche mit der Umschaltvorrichtung 20 wahlweise abhängig von der anliegenden Last in Serie oder parallel geschaltet werden können. Dadurch ist es möglich, je nach Anzahl der Transformatorsekundärkreise 23 die Spannungen zu verdoppeln oder zu vervielfachen und durch das Parallelschalten eine Spannungsbereichanpassung bzw. eine Leistungsanpassung vorzunehmen. Durch diese gesteuerte Arbeitspunktanpassung kann der Generator 1 jederzeit im opti-malen Lastbereich arbeiten, womit eine optimale und wirschaftliche Leistungsanpassung möglich ist zum Betrieb von verschiedenen Quellenmoden und Plasmamoden, wie Glimmentladung, abnormale Glimmentladung,Funkenverdampfer oder "Diffused Discharge". Ausserdem kann dadurch die Pulsausgangsstufe 8 an den Ausgängen 9, 9' die gewünschten Pulsformen unverfälscht zur Verfügung stellen, wie dies in Fig. 2 beispielsweise dargestellt ist. Für die gewünschte flexible Prozessführung kann die Pulsausgangsstufe (8) als Spannungskonverter ausgebildet werden mit zusätzlich einstellbarer Pulsbreitensteuerung zu Erzeugung von Pulsen mit vorgegebener Pulshöhe, Pulsbreite und Pulsfrequenz. Diese Werte können auch gesteuert moduliert werden.

Die erfindungsgemässe zweistufige Topologie kann wie in Fig. 2a dargestellt ist, je nach Ansteuerung auch eine reine DC-Spannung an den Ausgängen 9, 9' verfügbar machen. Diese Topologie ist aber besonders vorteilhaft verwendbar für den Pulsbetrieb, wie dies in Fig. 2b dargestellt ist als unipolarer Puls und in Fig. 2c als bipolarer Puls. Hierbei können die Pulsbreiten und die Pulsintervalle in weiten Bereichen eingestellt werden und müssen auch nicht symmetrisch sein. In Fig. 2c ist beispielsweise ein asymmetrischer bipolarer Betrieb dargestellt mit einem schmalen positiven Puls mit sehr langem Intervall und mit mehreren asymmetrisch vorliegenden negativen Pulsen mit kürzeren Intervallen. Da die Versorgung auch den Betrieb zwischen Plasmaquellen oder Elektroden, wie Substraten, unterschiedlicher Impedanz erlaubt, kommt es zu einer zusätzlichen Asymmetrie in der Pulshöhe. Diese kann über die Einstellung der Pulsbreite beeinflusst werden.

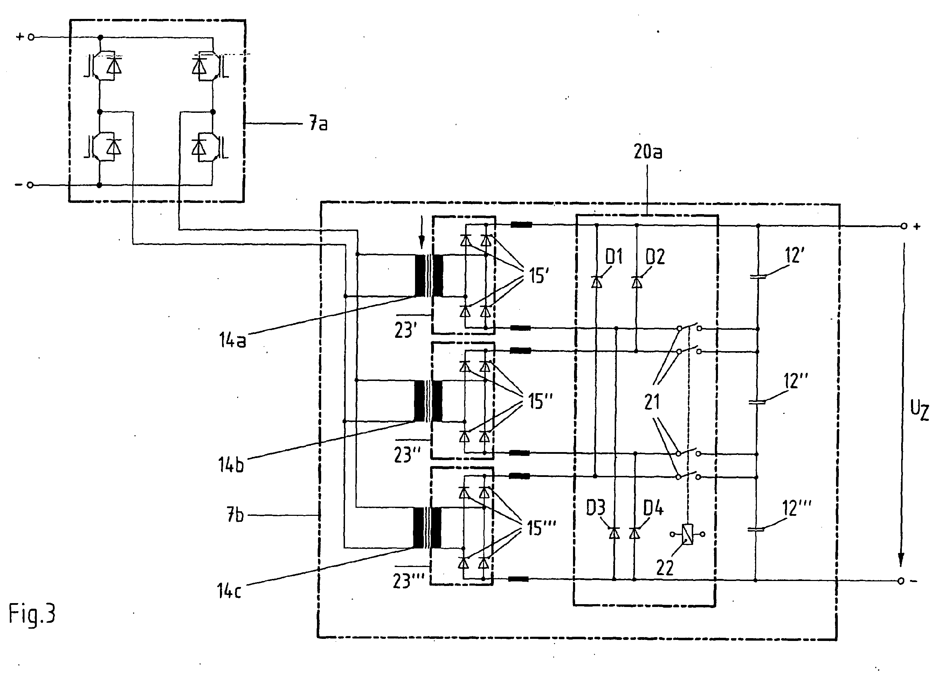

Der aufgebaute Generator verfügt wie in Fig. 3 gezeigt über drei Transformatoren 14a bis 14c, wobei auch jede andere Anzahl grösser eins zur Erlangung des Vorteils denkbar ist. Es kann auch ein Transformator mit mehreren voneinander isolierten Sekundärwicklungen eingesetzt werden. Am Transformator ist sekundärseitig ein separater Brückengleichrichter 15' bis 15''' mit Glättungsinduktivitäten als Zwischenkreiskondensator 12 nachgeschaltet. Zwischen den Gleichrichtern und einer Serienschaltung von Zwischenkreiskondensatoren 12 befindet sich eine Umschaltvorrichtung 20. Im höchsten Spannungsbereich speist Gleichrichter 15 einen Kondensator 12. Die Schalter der Umschaltvorrichtung 20 sind geschlossen und die Dioden D₁-D₄ der Umschaltvorrichtung sind aufgrund der Potentiale an den in Serie geschalteten Kondensatoren 12 in Sperrichtung gepolt und somit stromlos. Im niedrigsten Spannungsbereich werden über die Umschaltvorrichtung 20 alle Gleichrichter 15 parallel geschaltet. Die Schalter der Umschaltvorrichtung sind geöffnet und der Stromfluss findet über die Dioden D statt.

In Fig. 3 ist eine bevorzugte Ausführungsform eines DC-DC-Spannungskonverters 7 als erste Stufe ausgebildet des Generators 1 dargestellt. Der DC-DC-Konverter 7 verfügt über einen Konverterleistungsschalter 7a, welcher als Wechselrichter arbeitet, an welchen mehrere parallelgeschaltete Transformatoren 14a bis 14c angeschlossen sind. Der Konverterleistungsschalter 7a ist beispielsweise als Brückenschaltung bzw. als Vollbrücke ausgebildet und beinhaltet als elektronische Schaltelemente mit Vorteil IGBT-Transistoren. Die Sekundärwicklungen der Transformatoren 14a bis 14c sind mit Gleichrichtern 15, 15'-15''' verbunden und bilden gegeneinander isolierte schwebende Transformatorsekundärkreise 23. Der DC-DC-Spannungskonverter 7, wie er als Beispiel in Fig. 3 dargestellt ist, weist hier drei schwebende Transformatorsekundärkreise 23 auf. Es können je nach gewünschtem Spannungsbereich auch nur zwei schwebende Kreise oder aber auch mehrere schwebende Kreise eingesetzt werden. Die Transformatorsekundärkreise 23 sind mit einer Umschaltvorrichtung 20a derart verbunden, dass die schwebenden Transformatorsekundärkreise 23 wahlweise in Serie oder parallel geschaltet werden können, wodurch sich an den im Ausgangsbereich in Serie geschalteten Zwischenkreiskondensatoren 12' bis 12'" eine entsprechend vervielfachte Zwischenkreisspannung U_{z} einstellt. Eine vorteilhafte Ausbildung der Umschaltvorrichtung 20a besteht darin, dass jeweils ein Gleichspannungspol der Transformatorsekundärkreise 23 mit Dioden D1 bis D4 geschaltet werden und der andere Gleichspannungspol mit aktiven Schaltelementen 21. Die aktiven Schaltelemente können als mechanische Schalter ausgebildet sein oder wenn sehr schnell geschaltet werden muss auch als elektronische Schalter, die durch eine Schaltersteuerung 22 entsprechend den Anforderungen im geeigneten Prozesszustand gesteuert geschaltet werden. Die Anordnung 7b mit Konvertertransformatoren 14, Gleichrichtern 15 und Spannungsumschalter 20 ermöglicht somit eine wesentliche Erweiterung des Einstellbereiches der Zwischenkreisspannung U_{z}.

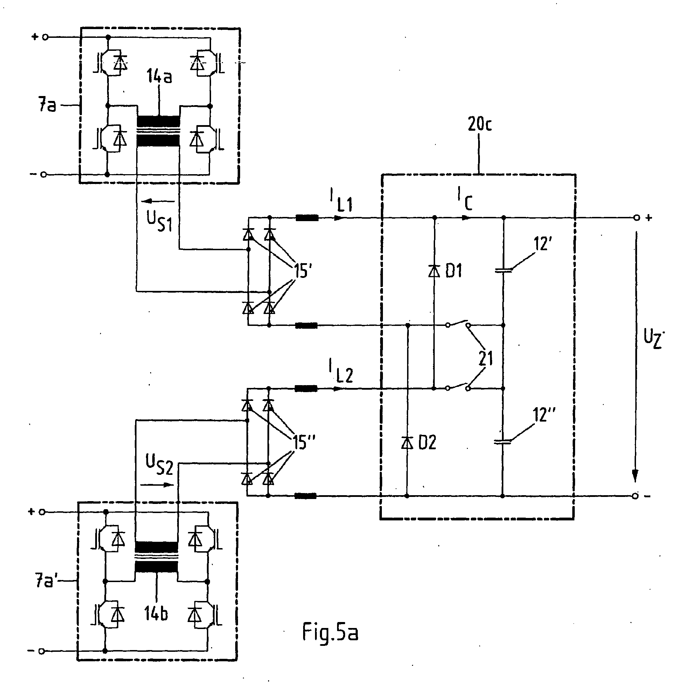

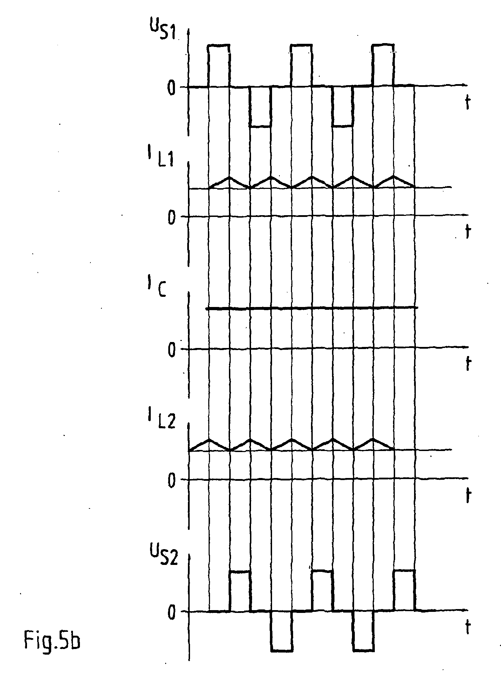

Bei einem derartigen Vakuumplasmagenerator 1 können ohne weiteres Nennleistungen bis zu 100 kW und darüber realisiert werden. Durch eine Anordnung mit mehreren vollbrükkenwandlern, wie in Fig. 5 dargestellt, kann die Nennleistung beispielsweise auf 400 kW erhöht werden. In Fig. 5a ist ein DC-DC-Konverter 7 dargestellt mit zwei unabhängigen vollbrückenschaltungen, welche zwei schwebende Transformaitorsekundärkreise 23 bilden mit der zugehörigen Umschaltvorrichtung 20c für die Erweiterung des Betriebsspannungsbereiches. Zur Verringerung der Strombelastung der Zwischenkreiskondensatoren 12', 12'' können die Wechselrichter mit den Transformatoren 14a, 14b auch phasenversetzt getaktet werden, wodurch auch der Rippel der Zwischenkreisspannung geringer gehalten wird, wie dies in der Fig. 5b mit den entsprechenden Strömen und Spannungen dargestellt ist. U_{S1} und U_{S2} bedeuten hierbei die Spannungswerte an den Seikundärwicklungen der Transformatoren 14 gemessen über die Zeit t. I_{L1} und I_{L2} sind die Ladeströme für die beiden Zwischenkreiskondensatoren 12', 12", wobei I_{c} der Gesamtladestrom darstellt.

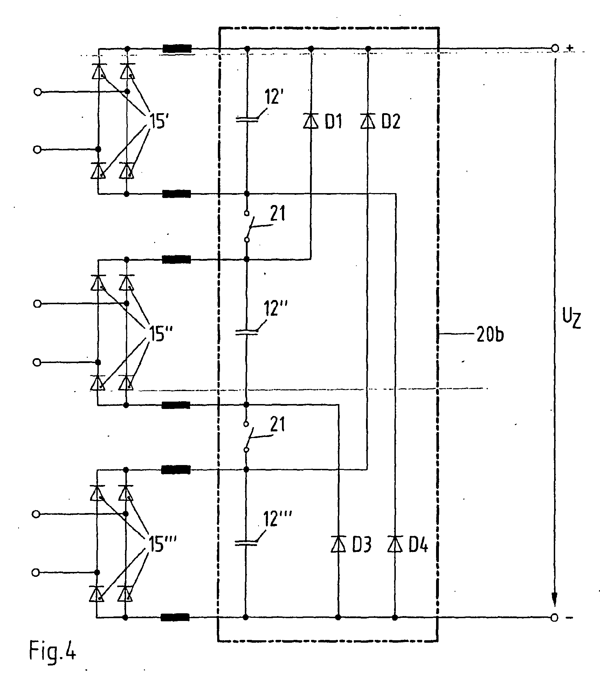

Eine weitere Möglichkeit der Ausführung ist in Fig. 4 dargestellt. Die Umschaltvorrichtung 20b ist hier nicht zwischen die Gleichrichter 15' bis 15''' und die Zwischenkreiskondensatoren 12' bis 12''' geschaltet, sondern schaltet die Anordnung der Kondensatoren 12 von einer Serienschaltung im hohen Spannungsbereich in eine Parallelschaltung im niedrigen Spannungsbereich. Für die Strombelastung der Kondensatoren 12 ist diese Variante vorteilhaft, da diese für beide Spannungsbereiche unverändert bleibt. Gegenüber der in Fig. 3 dargestellten Lösung ergibt sich der Nachteil, dass die Schalter 21 im Kreis der Kondensatoren 12 eingeschaltet sind und damit die Induktiviät erhöhen, was insbesondere bei einer gepulsten Ausgangsspannung weniger günstig ist.

Das Prinzip kann beispielsweise bei der Verwendung von vier sekundärseitigen Anschlüssen mit vier Gleichrichtern 15 erweitert werden, so dass drei Spannungsbereiche erhalten werden. Im höchsten Spannungsbereich sind alle Gleichrichter quasi in Serie geschaltet, im mittleren Spannungsbereich sind jeweils zwei parallel geschaltete Gleichrichter in Serie geschaltet und der niedrigste Spannungsbereich sieht die Parallelschaltung aller Gleichrichter vor.

Anstelle der dargestellten Dioden D1 bis D4 können ebenfalls elektromechanische Schalter eingesetzt werden oder bei grossen erforderlichen Schaltgeschwindigkeiten gesteuerte Halbleiterschaltelemente.

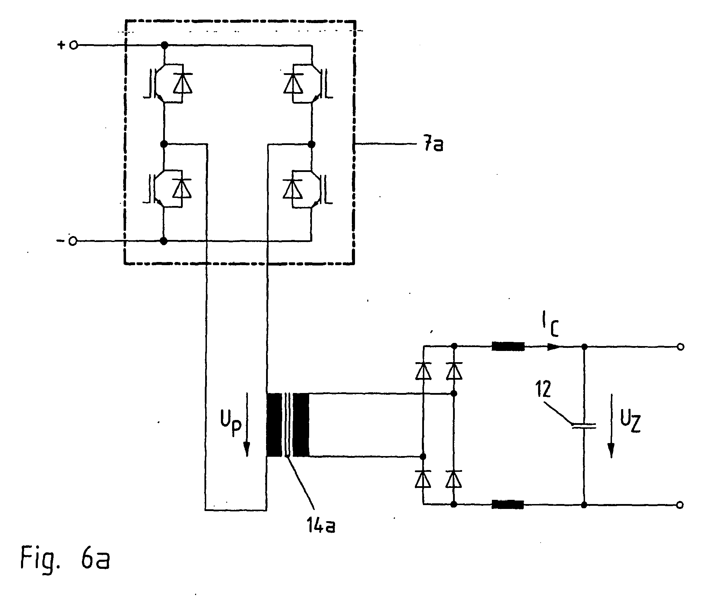

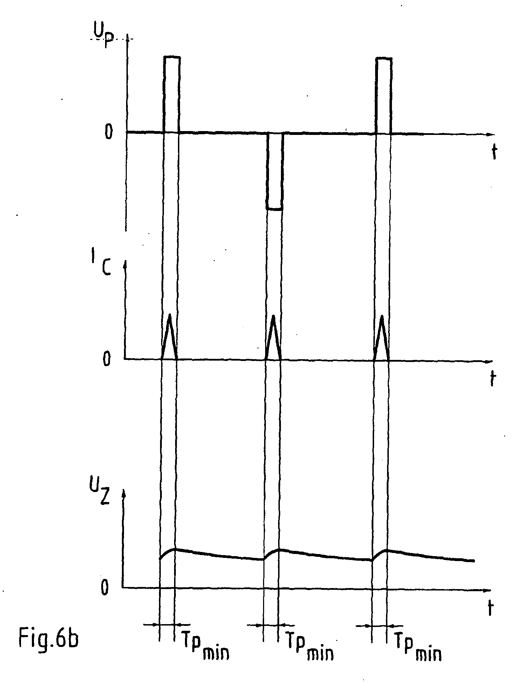

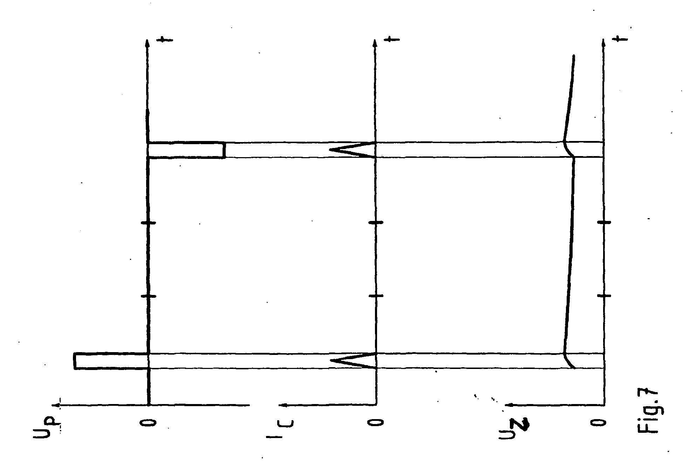

Bedingt durch die Verzörgerungszeiten beim Ein- und Ausi schalten der Halbleiterschaltelemente ist die minimale Pulsdauer t_{Pmin}, in der Halbleiterschalter eingeschaltet sind, begrenzt. Es können also keine beliebig kurzen Pulse erzeugt werden. Dies gilt insbesondere für im höheren Leistungsbereich eingesetzte IGBT-Leistungsschaltelemente. Das hat zur Folge, dass die minimale Ladung, mit der die Konbensatoren 12 des DC-DC-Konverterausgangs während einer Taktperiode nachgeladen werden, betragsmässig nach unten begrenzt ist, wie dies gemäss der Prinzipschaltung nach Fig. 6a und dem Spannungs- und Stromverlauf gemäss Fig. 6b dargestellt ist. Bei kleinen Ausgangsspannungen muss der DC-DC-Konverter daher im sogenannten Aussetzbetrieb betrieben werden. Das heisst, dass der Wandler in einigen Perioden nicht aktiv ist und die Ausgangskondensatoren 12 während dieser Perioden daher nicht nachgeladen werden, wie dies in Fig. 7 dargestellt ist. U_{P} zeigt den Verlauf der bipolaren Pulsspannung an der Primärseite des Transformators 14a und I_{c} den Ladestrom des Zwischenkreiskondensators 12 und U_{z} die Zwischenkreisspannung am Kondensator 12. t_{Pmin} bezeichnet die minimal mögliche Pulsbreite.

Der erfindungsgemässe Vakuumplasmagenerator 1 ermöglicht hierbei die Speisung von verschiedenen Plasmamoden im Pulsbetrieb, wie Glimmentladung, abnormale Glimmentladung, Funkenverdampfung bzw. Arcverdampfung oder "Diffused Discharge". Hierbei ist es möglich, einen grossen Spannungsbereich und Impedanzbereich für die verschieden Art der Last abzudecken. Ein bevorzugter Bereich ist 0 V bis 800 V Pulsspannung, welches ermöglicht die Moden der Funkenverdampfung mit einem Impedanzbereich von 0,05 Ohm bis 1,0 Ohm abzudekken und den Mode der "Diffused Discharge" in einem Impedanzbereich von 0,2 Ohm bis 3 Ohm. Es ist auch möglich nach Bedarf den Arbeitsbereich noch mehr zu erweitern, beispielsweise auf den Impedanzbereich von 10 Ohm bis 100 Ohm, welcher die Glimmentladungen und Sputteranwendungen umfasst. Es ist auch möglich, den Impedanzbereich zusätzlich von 50 Ohm bis 500 Ohm zu erfassen, welcher die abnormale Glimmentladung bei hohen Spannungen umfasst oder aber auch zusätzlich von 50 Ohm bis 5000 Ohm zu erweitern mit noch höheren Spannungswerten für die Plasmaentladung. Alle diese Impedanzbereiche können untereinander einzeln oder kombiniert erfasst werden je nach Erfordernis und Auslegung des Generators 1 mit der Umschalteinrichtung 20.

Mit einem derartigen Generator ist es nun auch möglich mit einer Umschalteinrichtung am Generatorausgang wahlweise zwei Plasmaquellen, auch mit verschiedenen Impedanzen, wahlweise in derselben Anlage zu betreiben. Um die Effizienz der Prozessanlage weiter zu erhöhen, können mit Vorteil mit einer geeigneten Umschaltvorrichtung sogar mehrere Plasmaquellen mit verschiedenen Impedanzen betrieben werden, welche dann bevorzugt sequentiell, nach vorgebbarem, auch automatisierbaren Ablauf mit derselben Stromversorgung verbunden werden. Je nach Arbeitspunkteinstellung der einzelnen Quelle oder der Art der angeschlossenen Quelle liegt am Generator eine unterschiedliche Lastimpedanz an welche mit dem vorliegenden Generator in weiten Bereichen beherrscht werden kann. Wenn beispielsweise die bipolaren Pulslängen unterschiedlich sind und sich die Spannungspulshöhen entsprechend auf die gerade anliegende Lastimpedanz einstellen ist es vorteilhaft wenn die Pulsbreiten verändert werden können, um diese Verhalten abhängig vom Vermögen der Leitungsabgabe des Generators kompensieren zu können. Die Variation der Lastverhältnisse kann beim bipolaren Betrieb sogar im positiven, wie auch im negativen Pulsast unterschiedlich auftreten. Insgesamt ermöglicht nun der erfinderische Generator einen impedanzkontrollierten Betrieb über weite Bereiche, auch gesteuert kontrolliert nach Sollvorgabe.

Bei derartigen Plasmaprozessen ist es oft wünschenswert einer DC - betriebenen Plasmaentladung eine Pulsspannung zu überlagern. Um dies zu ermöglichen ist eine elektrische Entkoppelung der Geräte notwendig. Dies wird ermöglicht da-(durch, **dass** der Generatorausgang (9, 9') an ein Filter angeschlossen ist, welches vorzugsweise Dioden enthält, welche die beiden Stromversorgungen elektrisch entkoppeln.

Die Generatoranordnung 1 ermöglicht das Bereitstellen von stabilen Pulsformen und insbesondere von Pulsen mit hoher Flankensteilheit. Für die erwähnten Plasmaprozesse ist es besonders vorteilhaft, wenn der Generator eine Flankensteilheit von steiler als 0,1 V/ns bereitstellt, vorzugsweise steiler als 1,0 V/ns. Eine besonders wichtige Betriebsweise ist das wahlweise Verwenden von Funkenverdampfern und / oder den Betrieb einer Plasmastrecke 10 am Werkstück 5 im sogenannten Biasbetrieb. Besonders bei der Abscheidung von isolierenden Schichten ist es vorteilhaft, wenn bipolare Pulse mit ungleichen Pulslängen verwendet werden können. Wegen der im Vergleich zu den Ionen höherer mobilität der Elektronen, genügen schon kleine positive Pulslängen , um die während des Schichtwachstums mit den Ionen aufgebrachten positiven Ladungen zu entladen. Die notwendige Zeit für die Entladung hängt von der -Elektronendichte des jeweiligen Plasmas ab. In den meisten Fällen sind positive Pulslängen von 10% oder weniger verglichen mit den negativen Pulslängen ausreichend. Es ist vorteilhaft positive Pulslängen von kleiner 5%, vorzugsweise gar kleiner 2% der negativen Pulsdauer zu verwenden. Die Betriebsweise bei welcher die Pulslänge weniger lang ist als die Hälfte der Periodendauer der Betriebsfrequenz wird auch als lückender Betrieb bezeichnet.

Mit einem derartigen Generator können auch gesteuert Pulspakete erzeugt werden, um einen gezielt dosierten Energieeintrag ins das Plasma zu realisieren.

## Patentansprüche

1. Vakuumplasmagenerator mit einem Generatorausgang (9, 9') zur Speisung einer Plasmaentladung (10) zur Behandlung von Werkstücken (5) in einer Vakuumkammer (2) mit einem Wechselspannungsnetzanschluss (6a), einer Netzgleichrichteranordnung (6) zur Umsetzung der Netzwechselspannung in eine Gleichspannung, einem Glättungskondensator (6b), einer ersten Stufe als getakteten DC/DC
- Spannungskonverter (7) mit Mitteln zur Einstellung DC
- Ausgangspannung welche eine Zwischenkreisspannung (Uz) bildet, enthaltend einen gesteuerten Leistungschalter (7a) der die Primärwicklung eines Transformators (14) speist, dessen Sekundärwicklung mit einem Gleichrichter (15) und einem nachgeschalteten Zwischenkreiskondensator (12) verbunden ist und einen schwebenden Transformatorsekundärkreis (23) bildet, wobei der DC DC Spannungskonverter (7) mindestens zwei schwebende Transformatorsekundärkreise (23) aufweist und eine Umschaltvorrichtung (20) mit einer Schaltersteuerung (22) enthält zur wahlweise parallelen oder seriellen Schaltung der schwebenden Transformatorsekundärkreise (23), **dadurch gekennzeichnet, dass** die Transformatorsekundärkreise mit einer nachgeschalteten zweiten Stufe verbunden sind, welche eine Puls - Ausgangsstufe (8) bildet, die an den Generatorausgang (9,9') angeschlossen ist, wobei als Mittel zur Einstellung der Zwischenkreisspannung (Uz) der Leistungschalter (78) pulsbreiten-gesteuert ist und die Schaltersteuerung (22) der Umschaltvorrichtung dazu ausgelegt ist, mit den umschaltbaren Transformatorsekundärkreisen (23) die Zwischenkreisspannung zusätzlich in Schritten nach Bedarf zu verdoppelen oder zu vervielfachen, zur Erweiterung des Spannungseinstellbereiches des DC/DC - Konverters.

2. Generator nach Anspruch 1, **dadurch gekennzeichnet, dass** die Umschaltvorrichtung (20) Schaltdioden (D) und gesteuerte Schalter (21) enthält.

3. Generator nach einem der vorhergehenden Ansprüche, **dadurch gekennzeichnet, dass** die Umschaltvorrichtung (20) gesteuerte elektronische Schalter (21), vorzugsweise mechanische Schalter (21) enthält.

4. Generator nach einem der vorhergehenden Ansprüche, **dadurch gekennzeichnet, dass** drei Transformatorsekundärkreise (23) mit Umschaltvorrichtung (20) vorgesehen sind.

5. Generator nach einem der vorhergehenden Ansprüche, **dadurch gekennzeichnet, dass** die Pulsausgangsstufe (8) als Spannungskonverter ausgebildet ist mit zusätzlich einstellbarer Pulsbreitensteuerung zur Erzeugung von Pulsen mit vorgegebener Pulshöhe, Pulsbreite und Pulsfrequenz.

6. Generator nach einem der vorhergehenden Ansprüche, **dadurch gekennzeichnet, dass** die der Spannungskonverter (7) und/oder die Pulsausgangsstufe (8) mit lückenden Pulsen betrieben werden kann.

7. Generator nach einem der vorhergehenden Ansprüche, **dadurch gekennzeichnet, dass** er derart ausgelegt ist, am Generatorausgang (9) mehrere Plasmaimpedanzbereiche abzudecken zur Speisung von verschiedenen Plasmamoden, wie Glimmentladung, abnormale Glimmentladung, Funkenverdampfung oder "Diffused Discharge".

8. Generator nach Anspruch 7, **dadurch gekennzeichnet, dass** die Plasmaimpedanzbereiche 0,05 Ohm bis 1,0 Ohm und 0,2 Ohm bis 3,0 Ohm umfassen.

9. Generator nach Anspruch 8, **dadurch gekennzeichnet, dass** die Plasmaimpedanzbereiche zusätzlich 10 Ohm bis 100 Ohm umfassen.

10. Generator nach einem der Ansprüche 7 bis 9, **dadurch gekennzeichnet, dass** die Plasmaimpedanzbereiche zusätzlich 50 Ohm bis 500 Ohm umfassen.

11. Generator nach einem der Ansprüche 7 bis 10, **dadurch gekennzeichnet, dass** die Plasmaimpedanzbereiche zusätzlich 50 Ohm bis 5000 Ohm umfassen.

12. Generator nach einem der vorhergehenden Ansprüche, **dadurch gekennzeichnet, dass** er derart ausgelegt ist, am Generatorausgang (9) eine Flankensteilheit der Pulse einzuhalten, die steiler als 0,1 Volt pro Nanosekunde ist, vorzugsweise steiler als 1,0 V/ns.

13. Generator nach einem der vorhergehenden Ansprüche, **dadurch gekennzeichnet, dass** er derart ausgelegt ist, am Generatosausgang (9, 9') unipolare und / oder bipolare Pulse bereit zu stellen.

14. Generator nach Anspruch 13, **dadurch gekennzeichnet, dass** die bipolaren Pulse ungleiche Pulslängen aufweisen, insbesondere beim Anschluss an das Werkstück (5) für Bias - Betrieb der negative Puls länger ist als der positive Puls, vorzugsweise die Pulslänge des positiven Pulses kleiner als 5%, bevorzugt kleiner 2% der negativen Pulsdauer ist.

15. Generator nach einem der vorhergehenden Ansprüche, **dadurch gekennzeichnet, dass** der Generatorausgang (9, 9') an eine Umschaltvorrichtung angeschlossen ist, welche mindestens zwei, vorzugsweise mehrere, Plasmaquellen (10) wahlweise verbindet, bevorzugt sequentiell verbindet.

16. Generator nach Anspruch 15, **dadurch gekennzeichnet, dass** der Generator derart ausgelegt ist, mit der Umschaltvorrichtung Plasmaquellen (10) mit unterschiedlichen Plasmaimpedanzen zu verbinden, vorzugsweise mit Impedanzbereichen nach den vorhergehenden Ansprüchen 7 bis 11.

17. Generator nach einem der vorhergehenden Ansprüche, **dadurch gekennzeichnet, dass** der Generatorausgang (9, 9') an ein Filter angeschlossen ist, vorzugsweise Dioden enthaltend, zur elektrischen Entkoppelung des Generators (1) von einer zugeschalteten, überlagerten DC - Speisung.

18. Generator nach Anspruch 13, **dadurch gekennzeichnet, dass** die bipolaren Pulslängen unterschiedlich sind und dass sich die Spannungspulshöhen entsprechend auf die anliegende Lastimpedanz einstellen und dass die Pulsbreiten verändert werden können.

## Claims

1. Vacuum plasma generator with a generator output (9, 9') to feed a plasma discharge (10) for treating workpieces (5) in a vacuum chamber (2) with an AC voltage network connection (6a), a power rectifier arrangement (6) to convert the network AC voltage into a DC voltage, a filter capacitor (6b), a first stage as a cycled DC/DC voltage converter (7) with means for setting a DC output voltage which forms an intermediate circuit voltage (Uz), containing a controlled power switch (7a) which feeds the primary winding of a transformer (14), the secondary winding of which is connected with a rectifier (15) and downstream intermediate circuit capacitor (12) and forms a floating transformer secondary circuit (23), wherein the DC/DC voltage converter (7) comprises at least two floating transformer secondary circuits (23) and contains a switch-over device (20) with a switch control (22) for optional parallel or serial switching of the floating transformer secondary circuits (23), **characterised in that** the transformer secondary circuits are connected with a downstream second stage which forms a pulse output stage (8) connected to the generator output (9, 9'), wherein as means for adjusting the secondary circuit voltage (Uz), the power switch (7"') is pulse-width controlled and the switch control (22) of the switch-over device is designed with the switchable transformer secondary circuits (23) to double or multiply the intermediate circuit voltage additionally in stages as required to expand the voltage adjustment range of the DC/DC converter.

2. Generator according to claim 1, **characterised in that** the switch-over device (20) contains switch diodes (D) and controlled switches (21).

3. Generator according to any of the preceding claims, **characterised in that** the switch-over device (20) contains controlled electronic switches (21), preferably mechanical switches (21).

4. Generator according to any of the preceding claims, **characterised in that** three transformer secondary circuits (23) with switch-over device (20) are provided.

5. Generator according to any of the preceding claims, **characterised in that** the pulse output stage (8) is formed as a voltage converter with additionally adjustable pulse width control to generate pulses with pre-specified pulse height, pulse width and pulse frequency.

6. Generator according to any of the preceding claims, **characterised in that** the voltage converter (7) and/or the pulse output stage (8) can be operated with gapped pulses.

7. Generator according to any of the preceding claims, **characterised in that** it is designed to cover several plasma impedance ranges at the generator output (9), to feed different plasma modes such as glow discharge, abnormal glow discharge, spark vaporisation or diffused discharge.

8. Generator according to claim 7, **characterised in that** the plasma impedance ranges comprise 0.05 Ohm to 1.0 Ohm and 0.2 Ohm to 3.0 Ohm.

9. Generator according to claim 8, **characterised in that** the plasma impedance ranges additionally comprise 10 Ohm to 100 Ohm.

10. Generator according to any of claims 7 to 9, **characterised in that** the plasma impedance ranges additionally comprise 50 Ohm to 500 Ohm.

11. Generator according to any of claims 7 to 10, **characterised in that** the plasma impedance ranges additionally comprise 50 Ohm to 5000 Ohm.

12. Generator according to any of the preceding claims, **characterised in that** it is designed to observe at the generator output (9) a pulse flank gradient which is steeper than 0.1 Volt per nanosecond, preferably steeper than 1.0 V/ns.

13. Generator according to any of the preceding claims, characterised that it is designed to provide unipolar and/or bipolar pulses at the generator output (9, 9').

14. Generator according to claim 13, **characterised in that** the bipolar pulses comprise unequal pulse lengths, in particular on connection to the workpiece (5) for bias operation, the negative pulse is longer than the positive pulse, preferably the pulse length of the positive pulse is less than 5%, preferably less than 2% of the negative pulse duration.

15. Generator according to any of the preceding claims, **characterised in that** the generator output (9, 9') is connected to a switch-over device which connects optionally, preferably sequentially, at least two, preferably more plasma sources (10).

16. Generator according to claim 15, **characterised in that** the generator is designed with the switch-over device to connect plasma sources (10) with different plasma impedances, preferably with impedance ranges according to any of the preceding claims 7 to 11.

17. Generator according to any of the preceding claims, **characterised in that** the generator output (9, 9') is connected to a filter, preferably containing diodes, for electrical decoupling of the generator (1) from a connected, overlaid DC voltage.

18. Generator according to claim 13, **characterised in that** the bipolar pulse lengths are different and that the voltage pulse heights can be set according to the load impedance applied and that the pulse widths can be changed.

## Revendications

1. Générateur de plasma sous vide disposant d'une sortie de générateur (9, 9') pour l'alimentation d'une décharge de plasma (10) destinée au traitement de pièces d'usinage (5) dans une chambre à dépression (2), comportant un raccord de branchement à un réseau sous tension alternative (6a), un ensemble redresseur de tension secteur (6) pour la conversion de la tension alternative du réseau en tension continue, un condensateur de lissage (6b), un premier étage faisant convertisseur de tension DC/DC en courant pulsé (7) à moyens de réglage de la tension DC de sortie fournissant une tension de circuit intermédiaire (Uz), qui comprend un interrupteur de puissance commandé (7a) alimentant l'enroulement primaire d'un transformateur (14) dont l'enroulement secondaire est relié à un redresseur (15) et de là à un condensateur de circuit intermédiaire (12) en formant un circuit secondaire de transformateur flottant (23), le convertisseur de tension DC/DC (7) comportant au moins deux circuits secondaires de transformateur flottants (23) et comportant un dispositif inverseur (20) à commutateur (22) pour commander la commutation des circuits secondaires de transformateur flottants (23) à volonté en parallèle ou en série, **caractérisé en ce que** les circuits secondaires de transformateur sont reliés vers l'aval à un second étage constituant étage de sortie en régime pulsé (8) qui est connecté à ladite sortie de générateur (9, 9'), le commutateur de puissance (7a) étant commandé en largeur de pulsation de manière à servir au réglage de la tension de circuit intermédiaire (Uz) et le commutateur (22) du dispositif inverseur étant en outre configuré pour augmenter cette tension de circuit intermédiaire en la multipliant par deux ou plus, par pas selon les besoins, à l'aide des circuits secondaires de transformateur commutables (23), de sorte que la plage de réglage de tension du convertisseur DC/DC s'en trouve élargie.

2. Générateur selon la revendication 1, **caractérisé en ce que** le dispositif inverseur (20) comporte des diodes de commutation (D) et des commutateurs commandés (21).

3. Générateur selon l'une quelconque des revendications précédentes, **caractérisé en ce que** le dispositif inverseur (20) comporte des commutateurs électroniques (21), de préférence des commutateurs mécaniques (21).

4. Générateur selon l'une quelconque des revendications précédentes, **caractérisé en ce qu'**il est prévu trois circuits secondaires de transformateur (23) pourvus d'un dispositif inverseur (20).

5. Générateur selon l'une quelconque des revendications précédentes, **caractérisé en ce que** l'étage de sortie en régime pulsé (8) est constitué d'un convertisseur de tension équipé en plus d'une commande de largeur d'impulsion réglable, de manière à générer des impulsions de hauteur, de largeur et de fréquence données.

6. Générateur selon l'une quelconque des revendications précédentes, **caractérisé en ce que** le convertisseur de tension (7) et/ou l'étage de sortie en régime pulsé (8) peuvent fonctionner avec des impulsions manquantes.

7. Générateur selon l'une quelconque des revendications précédentes, **caractérisé en ce qu'**il est configuré de manière à couvrir plusieurs gammes d'impédances de plasma au niveau de la sortie de générateur, afin de pouvoir alimenter différents modes de plasma, comme la décharge corona, la décharge corona anormale, l'évaporation par étincelles ou la "Diffused Discharge".

8. Générateur selon la revendication 7, **caractérisé en ce que** lesdites gammes d'impédance de plasma sont comprises entre 0,05 Ohm et 1,0 Ohm d'une part et entre 0,2 Ohm et 3,0 Ohms d'autre part.

9. Générateur selon la revendication 8, **caractérisé en ce que** les gammes d'impédance de plasma comportent en outre la gamme de 10 Ohms à 100 Ohms.

10. Générateur selon l'une des revendications 7 à 9, **caractérisé en ce que** les gammes d'impédance de plasma comportent en outre la gamme de 50 Ohms à 500 Ohms.

11. Générateur selon l'une des revendications 7 à 10, **caractérisé en ce que** les gammes d'impédance de plasma comportent en outre la gamme de 50 Ohms à 5000 Ohms.

12. Générateur selon l'une quelconque des revendications précédentes, **caractérisé en ce qu'**il est configuré pour assurer une pente de flanc des impulsions plus raide que 0,1 volt par nanoseconde, et de préférence plus raide que 1,0 V/ns.

13. Générateur selon l'une quelconque des revendications précédentes, **caractérisé en ce qu'**il est configuré de manière à fournir des impulsions unipolaires et / ou bipolaires au niveau de la sortie de générateur (9).

14. Générateur selon la revendication 13, **caractérisé en ce que** les impulsions bipolaires présentent des longueurs de pulsation inégales, avec en particulier en cas de raccordement à la pièce d'usinage (5) en fonctionnement polarisé une impulsion négative plus longue que l'impulsion positive, la longueur d'impulsion de l'impulsion positive étant de préférence inférieure à 5%, et de préférence inférieure à 2% de la durée de l'impulsion négative.

15. Générateur selon l'une quelconque des revendications précédentes, **caractérisé en ce que** la sortie de générateur (9, 9') est connectée à un dispositif inverseur, qui relie au choix au moins deux sources de plasma (10), de préférence plus, de préférence de manière séquentielle.

16. Générateur selon la revendication 15, **caractérisé en ce que** le générateur est configuré de manière à relier au dispositif inverseur des sources de plasma (10) dont les impédances de plasma sont différentes, et de préférence dans les gammes d'impédances selon les revendications précédentes 7 à 11.

17. Générateur selon l'une quelconque des revendications précédentes, **caractérisé en ce que** la sortie de générateur (9, 9') est connectée à un filtre, comportant de préférence des diodes, pour le découplage électrique du générateur (1) d'une alimentation en courant continu qui lui est raccordée.

18. Générateur selon la revendication 13, **caractérisé en ce que** les pulsations bipolaires sont de longueurs différentes et les hauteurs d'impulsion de tension se règlent en conséquence sur l'impédance de charge appliquée tandis que les largeurs d'impulsion peuvent être modifiées.
